# EUROPEAN PATENT APPLICATION

(11) **EP 2 248 663 A1**
(43) Date of publication of application: **10.11.2010**
(21) Application number: 09715665.7
(22) Date of filing: 26.02.2009
(51) Int. Cl.: B32B 15/088, B32B 15/08, C23C 26/00

(54) **MATERIAL FOR ELECTRICAL/ELECTRONIC COMPONENT AND ELECTRICAL/ELECTRONIC COMPONENT**

(30) Priority: 27.02.2008 JP 2008046021
(71) Applicant: The Furukawa Electric Co., Ltd., Chiyoda-ku Tokyo 100-8322 (JP)
(72) Inventor: TACHIBANA, Akira, Tokyo 100-8322 (JP); ITO, Takayori, Tokyo 100-8322 (JP); SUGAHARA, Chikahito, Tokyo 100-8322 (JP)
(74) Representative: Forstmeyer, Dietmar
(86) International application number: PCT/JP2009/053608
(87) International publication number: WO 2009/107752

(57) **Abstract**

A material for an electrical/electronic part, which has a resin coating directly formed on at least a part of a metal substrate or at least a part of a metal layer provided on the metal substrate, with the resin coating being formed with a resin composition containing at least one selected from the group consisting of a polyamideimide resin and a polyimide resin, each having a structure represented by formula (I) or (II) in the molecular structure: 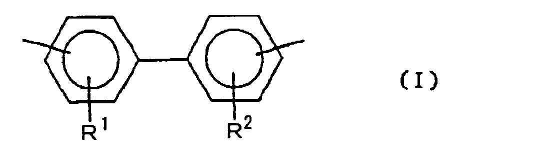 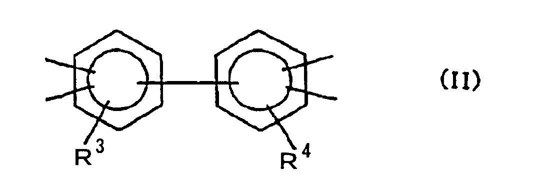 in which R¹, R², R³, and R⁴ each represent one selected from a hydrogen atom, an alkyl group, a hydroxyl group, a halogen atom, and an alkoxy group.

## Description

### TECHNICAL FIELD

The present invention relates to a material for an electrical/electronic part having a resin coating on a metal substrate, and to an electrical/electronic part.

### BACKGROUND ART

A material in which an electrically-insulating resin coating is provided on a metal base, such as a metal substrate, is used, for example, as a shielding material for a circuit board (see, Patent Literature 1). This material is suitably used for a housing, a case, a cover, a cap, and the like. In particular, it is believed that the material is particularly suitably used for a low-profile housing which builds-in a device(s) and has a lowered height of the inside space of the housing.

Further, as a method of enhancing adhesiveness between the metal bas>e, which is made of a metallic material and to which an insulating resin coating is attached, and the resin coating, known are: a method of applying a coupling agent to the surface of the metal base (see, Patent Literature 2); and a method of forming a plating layer having dendrite-shaped crystals on the surface of the metal base (see, Patent Literature 3).
{Patent Literature 1} JP-A-2004-197224 ("JP-A" means unexamined published Japanese patent application)
{Patent Literature 2} Japanese Patent No. 2802402
{Patent Literature 3} JP-A-5-245432

### DISCLOSURE OF INVENTION

### TECHNICAL PROBLEM

When the material provided with a resin coating on a metal base, such as a metal substrate, is applied as a material for the electrical/electronic part, this is worked as follows. For example, since this material is provided with the resin coating on the metal base, it is subjected to working, such as punching, at a part of the metal base and the resin coating including an interface of those, to form an electrical/electronic part, such as a connector contact. By this, the electrical/electronic part, such a connector contact, can be arranged at a narrow pitch, which allows a variety of applications.

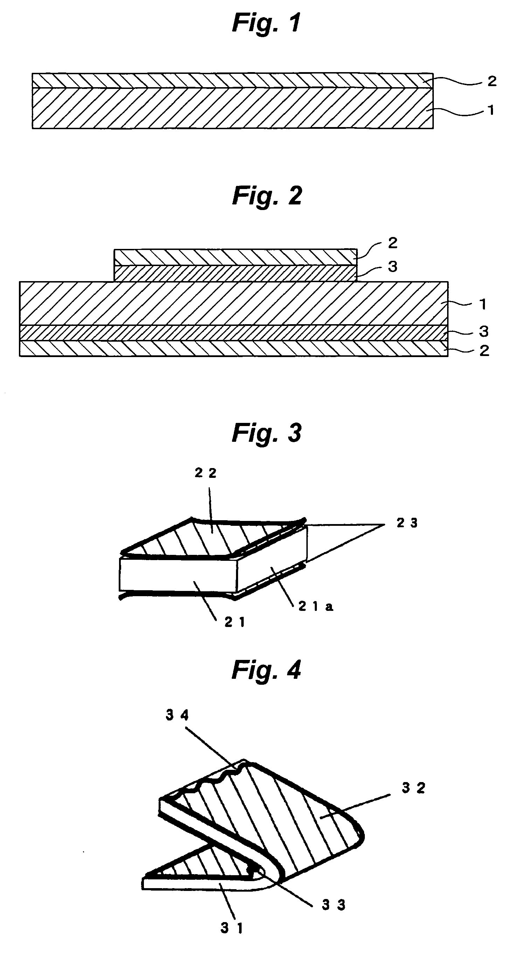

Meanwhile, when the conventional material is subjected to working, such as punching, at the portion including the interface between the metal base and the resin coating, a small gap of about several µm to several tens µm may occur between the metal base and the resin coating at the worked portion. This state is schematically shown in a perspective view in Fig. 3. In Fig. 3, 21 denotes a metal substrate, 22 denotes a resin coating, and a gap 23 is formed between the metal substrate 21 and the resin coating 22 in the vicinity of a punched surface 21 a of the metal substrate 21. This tendency becomes strengthened, as a clearance in the punching becomes larger (for example, at 5% or more to the thickness of the metal substrate). As there is actually an upper limit for reducing the clearance in punching, this can be expressed, in other words, that this tendency becomes strengthened, as the resultant worked piece becomes finer in size.

In such a state, due to secular change or the like, the resin coating 22 becomes completely peeled off from the metal substrate 21, and provision of the resin coating 22 on the metal substrate 21 becomes meaningless. On the other hand, providing of the resin coating after fine working needs much time and effort and brings about cost increase of the resultant products, which is not practical. Further, in the case where a metal exposed surface of the electrical/electronic part formed (for example, the punched surface 21 a) is to be used as a connector contact or the like, as one option, a metal layer may be later provided on the metal exposed surface (for example, the punched surface 21 a) by plating or the like. However, when immersing in a plating liquid, the plating liquid may flow in via the gap 23, which may cause peeling off of the resin coating 22 from the metal substrate 21.

Further, when bending is conducted after the working, such as punching, even if no gap is formed between the metal substrate and the resin coating at a worked portion upon the working, such as punching, a gap may be formed between the metal substrate and the resin coating after conducting the bending. This state is schematically shown in Fig. 4. In Fig. 4, 31 denotes a metal substrate, 32 denotes a resin coating, and a gap 33 is formed at an inner side of a bent portion of the metal substrate 31, and a gap 34 is formed at an end (particularly at an outer side upon bending) of the electrical/electronic part. As illustrated in Fig. 4, these gaps 33, 34 are prominently formed at the end of the electrical/electronic part, at the inner surface side and side surface of the bent portion of the bent electrical/electronic part, which gaps may cause peeling off of the resin coating 32 from the metal substrate 31.

Further, when attempting to employ the method of Patent Literature 2 as a method of enhancing adhesiveness between the metal base and the resin coating, there is a problem in that, as the liquid shelf life of a coupling agent is short, the liquid must be cautiously managed. Further, as it is difficult to homogeneously treat the entire surface of the metal base, it may have no effect at all on the fine gaps described above. When attempting to employ the method of Patent Literature 3, plating should be carried out under limited plating conditions to control the crystalline state of the plating layer to be formed. Thus, a caution is needed for the management thereof. Still further, to give sufficient adhesiveness, a plating thickness needs to be thicker than 1 µm. Thus, it is unfavorable from the viewpoint of cost, too.

The present invention is contemplated for providing a material for an electrical/electronic part, in which a high level of adhesiveness between a metal substrate and a resin coating is maintained even when working, such as punching, is conducted at a part of the material including an interface between the metal substrate and the resin coating, and for providing an electrical/electronic part that is formed with the material for an electrical/electronic part, and a method of producing the material for an electrical/electronic part.

### SOLUTION TO PROBLEM

According to the present invention, there is provided the following means:
(1) A material for an electrical/electronic part, comprising a resin coating directly formed on at least a part of a metal substrate or at least a part of a metal layer provided on the metal substrate, with the resin coating being formed with a resin composition containing at least one selected from the group consisting of a polyamideimide resin and a polyimide resin, each having a structure represented by formula (I) in the molecular structure of the resin, and/or a resin composition containing at least one selected from the group consisting of a polyamideimide resin and a polyimide resin, each having a structure represented by formula (II) in the molecular structure of the resin,
   wherein, in formula (I), R¹ represents one selected from a hydrogen atom, an alkyl group, a hydroxyl group, a halogen atom, and an alkoxy group; and R² represents one selected from a hydrogen atom, an alkyl group, a hydroxyl group, a halogen atom, and an alkoxy group, and
   wherein, in formula (II), R³ represents one selected from a hydrogen atom, an alkyl group, a hydroxyl group, a halogen atom, and an alkoxy group; and R⁴ represents one selected from a hydrogen atom, an alkyl group, a hydroxyl group, a halogen atom, and an alkoxy group;

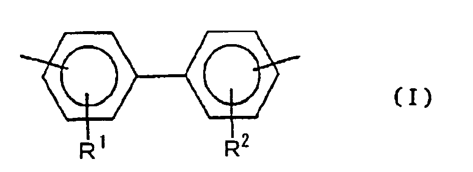

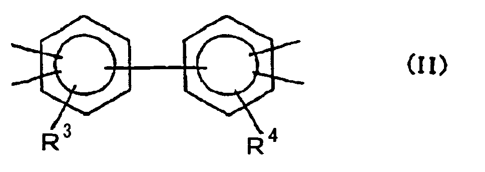

(2) The material for an electrical/electronic part as described in Item (1), wherein a part or the entire of the insulating layer (i.e. which means the resin coating as an insulating layer, and which is applied hereinafter) comprises a repeating unit derived from a monomer component having the structure represented by formula (I), and/or a repeating unit derived from a monomer component having the structure represented by formula (II), in an amount of 20 to 60 mol% to all the repeating units;
(3) The material for an electrical/electronic part as described in Item (1), wherein a part or the entire of the insulating layer comprises a repeating unit derived from a monomer component having the structure represented by formula (I), and/or a repeating unit derived from a monomer component having the structure represented by formula (II), in an amount of 35 to 55 mol% to all the repeating units;
(4) The material for an electrical/electronic part as described in any one of Items (1) to (3), which has one or more layers of the resin coating on the metal substrate;
(5) The material for an electrical/electronic part as described in any one of Items (1) to (4), wherein the metal substrate is composed of copper or a copper-based alloy, or iron or an iron-based alloy;
(6) The material for an electrical/electronic part as described in any one of Items (1) to (5), wherein n metal layers are provided on the metal substrate, in which n is an integer of 1 or more, and wherein the resin coating is provided on the metal substrate, directly or via at least one layer of the metal layer; and
(7) An electrical/electronic part, comprising the material for an electrical/electronic part as described in any one of Items (1) to (6).

### ADVANTAGEOUS EFFECTS OF INVENTION

According to the electronic part material of the present invention, it is possible to have the resin coating and the metal substrate adhere very strongly, and to give the material excellent in a punching property by pressing and a bending ability.

Other and further features and advantages of the invention will appear more fully from the following description, appropriately referring to the accompanying drawings.

### BRIEF DESCRIPTION OF THE DRAWINGS

{Fig. 1}
   Fig. 1 is a cross-sectional view illustrating an embodiment of the material for an electrical/electronic part according to the present invention.
{Fig. 2}
   Fig. 2 is a cross-sectional view illustrating another embodiment of the material for an electrical/electronic part according to the present invention.
{Fig. 3}
   Fig. 3 is a conceptual view illustrating an example of a state in which a gap is formed between a metal substrate and a resin coating of the conventional material for an electrical/electronic part.
{Fig. 4}
   Fig. 4 is a conceptual view illustrating another example of a state in which a gap is formed between a metal substrate and a resin coating of the conventional material for an electrical/electronic part.

### DESCRIPTION OF REFERENCE NUMERALS

1 Metal substrate
2 Resin coating
3 Metal layer
21, 31 Metal substrate
22, 32 Insulating coating
21 a Punched surface
23, 33, 34 Gap

### BEST MODE FOR CARRYING OUT THE INVENTION

Fig. 1 is a cross-sectional view illustrating a preferable embodiment of the material for an electrical/electronic part according to the present invention.
Fig. 1 shows an example in which the resin coating 2 is provided on the entire area of a single surface (the upper surface in this case) of the metal substrate 1. However, this is merely one example. That is, the resin coating 2 may be provided on the entire area of both surfaces (i.e. the entire upper surface and the entire bottom surface) of the metal substrate 1, or alternatively, it may be provided at a part of one surface (for example, the upper surface) and at a part of the other surface (for example, the bottom surface) of the metal substrate 1. In other words, the resin coating 2 may be provided on at least a part of the metal substrate 1. Further, the resin coating 2 may be provided on at least a part of one surface or both surfaces of the metal substrate 1 to have a stripe-like shape, a spot-like shape, or the like, or may be provided in plural numbers.

The material for an electrical/electronic part of the present invention has the resin coating 2 that is formed on at least a part of the metal substrate 1, in which the resin coating 2, which is formed with a resin composition containing at least one selected from the group consisting of a polyamideimide resin and a polyimide resin, each having a structure represented by formula (I) in the molecular structure of the resin, and/or a resin composition containing at least one selected from the group consisting of a polyamideimide resin and a polyimide resin, each having a structure represented by formula (II) in the molecular structure of the resin, is formed directly on at least a part of the metal substrate 1. Herein, the expression "being formed directly" means "being without any intermediately matter, e.g. an adhesive."

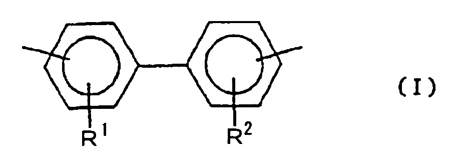

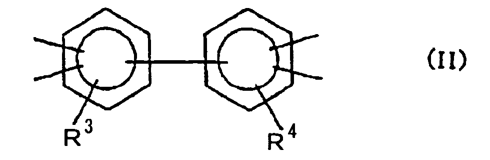

In formula (I), R¹ and R², which may be the same or different from each other, each represent a hydrogen atom, an alkyl group (preferably an alkyl group having 1 to 5 carbon atoms, for example, methyl, ethyl, and butyl), a hydroxyl group, a halogen atom (for example, a chlorine atom, a bromine atom, and a fluorine atom), or an alkoxy group (preferably an alkoxy group having 1 to 5 carbon atoms, for example, methyloxy, ethyloxy, and butyloxy).

Further, in formula (II), R³ and R⁴, which may be the same or different from each other, each represent a hydrogen atom, an alkyl group, a hydroxyl group, a halogen atom, or an alkoxy group, and specific examples and preferred range thereof have the same meanings as those described above for R¹ and R² in formula (1).

In the present invention, the polyamideimide resins and the polyimide resins, which are used to form the resin coating 2 as an insulating layer, may be prepared, by using synthetic raw materials, which are obtained by mixing raw materials of dicarboxylic acids, tricarboxylic acids, tetracarboxylic acids, or acid anhydrides or acid dianhydrides thereof, diisocyanates, or diamines, at least one of which has the structure of formula (I) and/or formula (II) in the molecule thereof, with other dicarboxylic acids, tricarboxylic acids, tetracarboxylic acids, or acid anhydrides or acid dianhydrides thereof, diisocyanates, or diamines.

Specific examples of the dicarboxylic acid having the structure represented by formula (I) include 4,4'-biphenyldicarboxylic acid, 3,3'-biphenyldicarboxylic acid, 3,3'-dimethyl-4,4'-biphenyldicarboxylic acid, 3,3'-diethyl-4,4'-biphenyldicarboxylic acid, 3,3'-dihydroxy-4,4'-biphenyldicarboxylic acid, 3,3'-dichloro-4,4'-biphenyldicarboxylic acid, 3,3'-dimethyloxy-4,4'-biphenyldicarboxylic acid, 3,3'-diethyloxy-4,4'-biphenyldicarboxylic acid, 4,4'-dimethyl-3,3'-biphenyldicarboxylic acid, 4,4'-diethyl-3,3'-biphenyldicarboxylic acid, 4,4'-dihydroxy-3,3'-biphenyldicarboxylic acid, 4,4'-dichloro-3,3'-biphenyldicarboxylic acid, 4,4'-dimethyloxy-3,3'-biphenyldicarboxylic acid, 4,4'-diethyloxy-3,3'-biphenyldicarboxylic acid, 2,2'-dimethyl-4,4'-biphenyldicarboxylic acid, 2,2'-diethyl-4,4'-biphenyldicarboxylic acid, 2,2'-dihydroxy-4,4'-biphenyldicarboxylic acid, 2,2'-dichloro-4,4'-biphenyldicarboxylic acid, 2,2'-dimethyloxy-4,4'-biphenyldicarboxylic acid, and 2,2'-diethyloxy-4,4'-biphenyldicarboxylic acid. These can be used singly or as a mixture of two or more thereof. Among these, 4,4'-biphenyldicarboxylic acid, and 3,3'-dimethyl-4,4'-biphenyldicarboxylic acid are preferred, and 4,4'-biphenyl dicarboxylic acid is particularly preferred.

Further, specific examples of the tetracarboxylic acid and the tetracarboxylic acid dianhydride, each having the structure represented by formula (II), include 3,3',4,4'-biphenyltetracarboxylic acid and acid dianhydride thereof, and 3,3',4,4'-biphenyltetracarboxylic acid and acid dianhydride thereof, and further include a compound having the molecular structure which has a functional group, such as -OH, -CH₃, or -Cl, as a substituent thereon . These can be used singly or in combination of two or more thereof. Among these, 3,3',4,4'-biphenyltetracarboxylic acid dianhydride, and 2,2'-dimethyl-3,3',4,4'-biphenyltetracarboxylic acid dianhydride are preferred, and 3,3',4,4'-biphenyltetracarboxylic acid dianhydride is particularly preferred.

Specific examples of the diisocyanate having the structure represented by formula (I) include biphenyl-4,4'-diisocyanate, biphenyl-3,3'-diisocyanate, biphenyl-3,4'-diisocyanate, 3,3'-dichlorobiphenyl-4,4'-diisocyanate, 2,2'-dichlorobiphenyl-4,4'-diisocyanate, 3,3'-dibromobiphenyl-4,4'-diisocyanate, 2,2'-dibromobiphenyl-4,4'-diisocyanate, 3,3'-dimethylbiphenyl-4,4'-diisocyanate (4,4'-bitolylenediisocyanate(TODI)), 2,2'-dimethylbiphenyl-4,4'-diisocyanate, 2,3'-dimethylbiphenyl-4,4'-diisocyanate, 3,3'-diethylbiphenyl-4,4'-diisocyanate, 2,2'-diethylbiphenyl-4,4'-diisocyanate, 3,3'-dimethoxybiphenyl-4,4'-diisocyanate, 2,2'-dimethoxybiphenyl-4,4'-diisocyanate, 2,3'-dimethoxybiphenyl-4,4'-diisocyanate, 3,3'-diethoxybiphenyl-4,4'-diisocyanate, 2,2'-diethoxybiphenyl-4,4'-diisocyanate, and 2,3'-diethoxybiphenyl-4,4'-diisocyanate. These can be used singly or in combination of two or more thereof. Among these, 3,3'-dimethylbiphenyl-4,4'-diisocyanate, and 3,3'-diethoxybiphenyl-4,4'-diisocyanate are preferred, and 3,3'-dimethylbiphenyl-4,4'-diisocyanate is particularly preferred.

Specific examples of the diamine having the structure represented by formula (I) include benzidine, 3,3'-dimethylbenzidine, and 2,2'-dihydroxybenzidine. These can be used singly or in combination of two or more thereof. Among these, 3,3'-dimethylbenzidine, and 3,3'-dihydroxyethylbenzidine are preferred, and 3,3'-dimethylbenzidine is particularly preferred.
The polyamideimide resin used in the present invention can be obtained in a usual manner, for example, by allowing a tricarboxylic acid anhydride alone, or a mixture of a tricarboxylic acid anhydride partially substituted with a dicarboxylic acid and/or a tetracarboxylic acid dianhydride, or a mixture of a dicarboxylic acid and a tetracarboxylic acid dianhydride, to react directly with a diisocyanate, in a polar solvent. Alternatively, it can be obtained, by allowing, in a polar solvent, an oligomer which has an imido bond introduced therein and which is obtained by a reaction of 2 moles of a tetracarboxylic acid dianhydride to 1 mole of a diamine, to react with an oligomer which has an amido bond introduced therein and which is obtained by a reaction of 1 mole of a dicarboxylic acid to 2 moles of a diisocyanate.

As the synthetic raw material that is used in the preparation of the polyamideimide resin, use is made of at least one of an acid component, a diisocyanate, and a diamine, each having the structure represented by formula (I) and/or (II); and, as other synthetic raw material in combination with the above at least one, use may be made, for example, of an acid component, such as trimellitic acid, isophthalic acid, terephthalic acid, trimellitic acid anhydride, pyromellitic acid dianhydride, 3,3',4,4'-benzophenonetetracarboxylic acid dianhydride, and a derivative thereof; an aromatic diisocyanate, such as 4,4'-diphenylmethane diisocyanate (MDI), and tolylene diisocyanate (TDI); and an aromatic diamine, such as m-phenylenediamine, 4,4'-diaminodiphenyl ether, 4,4'-diaminodiphenylmethane, 4,4'-diaminodiphenylsulfone, and 4,4'-diaminobenzophenone.

As the solvent that can be used in the synthesis, any one may be used which can dissolve the resin to be prepared. For example, N,N'-dimethyl formamide, or N,N'-dimethyl acetamide may be used. Preferably, N-methyl-2-pyrrolidone may be used.

Specific examples of a method of synthesizing the polyamideimide resin that can be used in the present invention, include a method in which a mixture of 4,4'-biphenyldicarboxylic acid and trimellitic acid anhydride is used as the acid component, 4,4'-diphenylmethanediisocyanate is used as the diisocyanate component, and the reaction is carried out in a polar solvent, for example, N-methyl-2-pyrrolidone, to obtain an polyamideimide resin insulating coating (a resin composition), which is the most simple and convenient method. Further, the polyamideimide resin coating may be obtained in a similar manner, by changing 4,4'-biphenyldicarboxylic acid, which is used in the example above, to 3,3',4,4'-biphenyltetracarboxylic acid dianhydride. In the former case, the amide component will be present more than the imide component. In the latter case, the opposite result will be obtained.
By applying the polyamideimide resin insulating coating as obtained in the above, directly onto the metal substrate 1, followed by baking, the resin coating 2 is formed on the metal substrate 1.

In the present invention, the polyimide resin that is used for the resin coating as the insulating layer, can be prepared in a usual manner. It corresponds to a method in which a solution of a polyamide acid resin is obtained by allowing a tetracarboxylic acid dianhydride to react with a diamine in a polar solvent, and the resultant solution is subjected to imidation by dehydration according to a heat treatment for producing an electric wire using the solution.

Another example of the method is a direct imidation in which a tetracarboxylic acid dianhydride and a diisocyanate are allowed to react with each other in a polar solvent. In this case, since the polyimide in the resultant resin solution is hardly dissolved in a solvent, it is necessary to select those easily soluble in the monomer component to be used. For example, as the tetracarboxylic acid component, by using 3,3',4,4'-biphenylsulfonetetracarboxylic acid dianhydride rather than pyromellitic acid dianhydride, the resultant polyimide is more easily dissolved in the solvent. Further, as the diisocyanate component, by using 2,6-tolylenediisocyanate rather than 4,4'-diphenylmethanediisocyanate, a polyimide with a better solubility is obtained.

In those cases, the tetracarboxylic acid dianhydride may be used singly or as a mixture of two or more thereof. Similarly, the diamine or diisocyanate may be used singly, or as a mixture of two or more thereof.
Further, in the present invention, in the case of employing a resin coating containing both of the polyamideimide resin and the polyimide resin, the polyamideimide resin composition and the polyimide resin composition, prepared separately, may be mixed with each other at the time of application and baking, to form a single resin coating. Alternatively, a single resin mixture containing both of the polyamideimide resin and the polyimide resin is prepared first, and then it may be subjected to the application and baking, to form a resin coating.

Further, without affecting the object of the invention, to the resin composition, addition may be made of any of hitherto known various additives that can be added to insulating layers (for example, a lubricant, an inorganic fine-powder, and a metal alkoxylate).

In the present invention, the polyamideimide resin or the polyimide resin is obtained by using at least one of the acid component, the diisocyanate, and the diamine, each having the structure represented by formula (I) and/or (II) as a raw material for synthesis, and the insulating layer with high hardness is formed with the resin. In the present invention, it is preferable that the polyamideimide resin or the polyimide resin has the repeating unit derived from the monomer component having the structure represented by formula (I) or (II) in the range of 20 to 60 %mol, more preferably in the range of 35 to 55 %mol, to the sum total of the whole acid components, diisocyanates, and diamines constituting the resin.

In the present invention, the resin coating 2 which is formed by applying and baking of the resin composition containing the polyamideimide resin and/or polyimide resin having the molecular structure represented by formula (I) and/or (II), directly on the metal substrate 1 or on the metal layer provided on the metal substrate 1, is excellent in a insulating property and mechanical strength, and has a very strong adhesiveness to the metal substrate 1.
With respect to the adhesiveness between the metal substrate 1 and the resin coating 2, the peeled width of resin coating 2 at the end of the material upon punching, is preferably less than 5 µm, more preferably less than 3 µm.

In the present invention, among all of the monomers constituting the resin which forms the resin coating 2, the polyamideimide resin contains the repeating unit derived from 3,3'-dimethylbiphenyl-4,4'-diisocyanate (4,4'-bitolylene diisocyanate (TODI)) preferably in an amount of 20 to 60 mol%, more preferably in an amount of 35 to 55 mol%, as the monomer component having the structure represented by formula (I) and/or formula (II).

In the present invention, examples of the metal substrate 1 include a metal strip, a metal foil, and a metal sheet. The thickness of the metal substrate 1 is preferably 0.01 to 1 mm, more preferably 0.04 to 0.4 mm, and still more preferably 0.04 to 0.3 mm.

From the viewpoints of conductivity and the like, as the metal substrate 1, use may be preferably made of copper or a copper-based alloy, or iron or an iron-based alloy. Examples of the copper-based alloy include phosphor bronze (Cu-Sn-P-based), brass (Cu-Zn-based), nickel silver (Cu-Ni-Zn-based), and Corson alloy (Cu-Ni-Si-based). Examples of the iron-based alloy include SUS (Fe-Cr-Ni-based), and 42 alloy (Fe-Ni-based).

The thickness of the metal substrate 1 is preferably 0.04 mm or more. If the metal substrate 1 is thinner than 0.04 mm, sufficient strength as an electrical/electronic part is not ensured. On the other hand, if it is too thick, the absolute value of clearance upon punching becomes high so that sagging of the punched portion becomes large. Thus, the thickness is preferably 0.4 mm or less, more preferably 0.3 mm or less. As explained in the above, the upper limit of the thickness of the metal substrate 1 is determined, by taking into consideration of an influence by working, such as punching (e.g. clearance, and size of sagging).

The metal substrate 1 can be produced via the steps, for example, of: melting and molding a given metal material, and subjecting the thus-obtained ingot to, in a usual manner, hot rolling, cold rolling, homogenization treatment, and degreasing, in this order.

In the present invention, as the metal layer, n metal layers may be provided on the metal substrate (n is an integer of 1 or more). The metal layer is provided, for example, to protect the surface of the metal substrate. With respect to the form of the resin coating provided on the metal substrate, the resin coating may be provided directly on the metal substrate, or the resin coating may be provided thereon via at least one metal layer as described above.
Fig. 2 is a cross-sectional view illustrating another embodiment of the material for an electrical/electronic part, in which a metal layer is provided. As shown in Fig. 2, in the material for an electrical/electronic part of this embodiment, a metal layer 3 is provided between the metal substrate 1 and the resin coating 2. The resin coating 2 is formed directly on the metal layer 3. A specific example thereof is that formed by application and baking of the resin composition containing the polyamideimide resin and/or the polyimide resin, each having the molecular structure represented by formula (I) and/or (II), directly on the metal layer 3. The number (n) of metal layers 3 is preferably 1 to 2, from the viewpoints of favorably maintaining a punching property by pressing and a bending property. In the case where the metal layer 3 is provided on the metal substrate 1, since the resin composition containing the polyamideimide resin and/or the polyimide resin, each having the molecular structure represented by formula (I) and/or (II), is directly applied to and baked on the metal layer 3, to form the resin coating 2, the adhesiveness between the metal layer 3 and the resin coating 2 can be enhanced.

The metal layer 3 is preferably formed by electrical plating, chemical plating, or the like. Further, it is preferably constituted with a metal selected from Ni, Zn, Fe, Cr, Sn, Si and Ti, or an alloy of these metals (for example, a Ni-Zn alloy, a Ni-Fe alloy, and a Fe-Cr alloy).
When the metal layer 3 is formed by plating, either wet plating or dry plating may be employed. Examples of the wet plating include electrolytic plating, and non-electrolytic plating. Examples of the dry plating include physical vapor deposition (PVD), and chemical vapor deposition (CVD).

With respect to the thickness of the metal layer 3, if is too thin, an effect of protecting the surface of the metal substrate 1 is not enhanced, and also the adhesiveness between the metal layer 3 or the metal substrate 1 and the resin coating 2 may be lowered. On the other hand, if the metal layer 3 is too thick, the punching property by pressing or the bending property tends to deteriorate. Thus, the thickness of the metal layer 3 is preferably 0.001 to 1 µm, more preferably 0.005 to 0.5 µm.

Fig. 2 shows an example in which the resin coating 2 is provided on a part of one surface (the upper surface in this case) of the metal substrate 1 and on the entire area of the other surface (the bottom surface in this case) of the metal substrate 1. However, this is merely one example. That is, the resin coating 2 may be provided on the entire area of both surfaces (i.e. the entire upper surface and the entire bottom surface) of the metal substrate 1, or alternatively, it may be provided at a part of one surface (for example, the upper surface) and at a part of the other surface (for example, the bottom surface) of the metal substrate 1. In other words, the resin coating 2 may be provided on at least a part of the metal substrate 1. Further, the resin coating 2 may be provided on at least a part of one surface or both surfaces of the metal substrate 1 to have a stripe-like shape, a spot-like shape, or the like, or may be provided in plural numbers.

In the present invention, as a method of providing the resin coating 2 containing the above-mentioned resin on the metal substrate 1, the resin composition containing of the resin is directly applied to and baked on the metal substrate 1 or on the metal layer 3 provided on the metal substrate 1, in a portion of the metal base at which insulation is needed. Specific examples thereof include a method which comprises, applying a varnish containing the resin or the resin precursor dissolved in a solvent, volatilizing the solvent, and heating, to cause reaction, curing, and adhesion.

With respect to the thickness of the insulating coating 2, if is too thin, an insulating effect cannot be obtained. On the other hand, if it is too thick, it is difficult to carry out punching. Thus, the thickness is preferably 2 to 20 µm, more preferably 3 to 10 µm.

Further, after subjecting the material for an electrical/electronic part of the present invention to a certain working, such as punching, a wet-type post-treatment may be conducted, on a site at which the resin coating 2 is not provided. The site at which the resin coating 2 is not provided means, for example, in Fig. 4, a side surface of the metal substrate 1, or a site other than the portion of the partial upper surface of the metal substrate 1 which is provided with the resin coating 2 thereon. Examples of the wet-type treatment that can be used herein, include wet plating (e.g. Ni plating, Sn plating, and Au plating), water-based cleaning (e.g. acid pickling, and alkaline degreasing), and solvent cleaning (e.g. ultrasonic treating). For example, the surface of the metal substrate 1 can be protected by providing a metal layer made through the post-treatment of wet plating. With respect to the material for an electrical/electronic part of this embodiment, the adhesiveness between the metal substrate 1 and the resin coating 2 is enhanced, by using the resin composition containing the polyamideimide resin and/or the polyimide resin, each having the molecular structure represented by formula (I) and/or (II). As a result, it is advantageous in that the resin coating 2 is not peeled off from the metal substrate 1, even when the metal layer made through the post-treatment is provided by post-working, such as plating.

The thickness of the metal layer made through the post-treatment is appropriately determined, regardless of the absence or presence of the metal layer 3 or the thickness of the metal layer 3 when it is present. It may be in the range of 0.001 to 1 µm, which is the same as that of the metal layer 3. The metal used for the metal layer made through the post-treatment is appropriately selected, depending on the usage of the electrical/electronic part. When it is used for an electric contact, a connector, or the like, Au, Ag, Cu, Ni and Sn, or an alloy containing any of these metals is preferable.

Further, the material for an electrical/electronic part of the present invention in which a resin coating is formed on a metal substrate, may be used for any kind of electrical/electronic parts. The part is not particularly limited, and examples thereof include a connector, and a module case. It may be also employed for an electrical/electronic equipment, such as a mobile phone, a personal digital assistance, a notebook computer, a digital camera, and a digital video.

### EXAMPLES

The present invention will be described in more detail based on examples given below, but the invention is not meant to be limited by these.

With respect to the materials for electrical/electronic parts according to the following Examples and Comparative examples, compositions (molar ratios) of resins which constituted the resin coatings are summarized in Table 1.

The polyamideimide resin-based insulating coatings (resin compositions) and the polyimide resin-based insulating coatings (resin compositions) were prepared, in the following manner, respectively.
To a three-neck flask (three-liter volume) equipped with a condenser and configured to allow an inert gas to be introduced thereto, a mechanical stirring apparatus and a heating apparatus were equipped. To the flask, N-methyl-2-pyrrolidone as a solvent, and xylene as a dehydration solvent, were placed in a ratio of 8:2 (weight ratio). Thereto, components of the polyhydric carboxylic acid and the polyhydric isocyanate, as shown in Table 1, were added, at room temperature under stirring, such that the total of the polyhydric carboxylic acid component(s) would be equimolar to the total of the polyhydric isocyanate component(s). Then, the solvent was adjusted, to have 25% concentration of the total solid matter, followed by raising the temperature of the system to 140°C to allow the reaction to take place.
The reaction was continued for about four hours, followed by cooling to room temperature, thereby to give the polyamideimide resin (Al-0 to Al-7)-based insulating coatings (resin compositions), or the polyimide resin (PI-1 to PI-2)-based insulating coatings (resin compositions), respectively.

### {Table 1}

**Table 1**

| Component in resin | | Polyamideimide resin | | | | | | | | Polyimide resin | |
|---|---|---|---|---|---|---|---|---|---|---|---|
| | | AI-0 | AI-1 | AI-2 | AI-3 | AI-4 | AI-5 | AI-6 | AI-7 | PI-1 | PI-2 |
| Polyhydric carboxylic acid | TMA | 50 | 25 | 25 | 25 | 45 | 40 | | 37.50 | | |
| | BDAc | | 25 | | | | | 25 | | | |
| | BPDA | | | 25 | | | | 25 | 12.50 | 25 | 25 |
| | OPDA | | | | 25 | | | | | 25 | |
| | PMDA | | | | | 5 | | | | | 25 |
| | BTDA | | | | | | 10 | | | | |
| Polyhydric isocyanate | MDI | 50 | 50 | 50 | 25 | | | | | | |
| | TDI | | | | | 15 | 10 | 50 | 8.75 | 50 | 50 |
| | TODI | | | | 25 | 35 | 40 | | 41.25 | | |
| Ratio of the components of formula (I) or (II) in the whole monomers (mol%) | | 0 | 25 | 25 | 25 | 35 | 40 | 50 | 53.75 | 25 | 25 |

| | | | | | | | | | | | |
|---|---|---|---|---|---|---|---|---|---|---|---|
| TMA: Trimellitic acid anhydride BDAc: 4,4'-biphenyldicarboxylic acid BPDA: 3,3',4,4'-biphenyltetracarboxylic acid dianhydride OPDA: 3,3',4,4'-oxydiphthalic acid dianhydride PMDA: Pyromellitic acid dianhydride BTDA: 3,3',4,4'-benzophenonetetracarboxylic acid dianhydride MDI: 4,4'-diphenylmethane diisocyanate TDI: Tolylene diisocyanate TODI: 4,4'-bitolylene diisocyanate | | | | | | | | | | | |

The resins of AI-1 to AI-7 and PI-1 to PI-2 each had the structure represented by formula (I) and/or (II) in the molecular structure of the respective resin. The ratios of the monomer(s) which had the structure represented by formula (I) and (II) to the total monomers contained in the raw materials for synthesis, are also shown in Table 1. The resin of AI-0 did not have any structure represented by formula (I) and/or (II) in the molecular structure of the resin. Further, in addition to the resin of AI-0, as comparative examples which did not contain such structures represented by formula (I) and/or (II), the following insulating coatings were utilized, that is, either HI-406A (trade name), manufactured by Hitachi Chemical Company, Ltd., a polyamideimide resin-based one in which a trimellitic acid anhydride (TMA) component was used as a raw material, or Pyre-ML (registered trademark), manufactured by IST, USA (Industrial Summit Technology, USA)), a polyimide resin-based one in which a pyromellitic acid dianhydride (PMDA) component was used as a raw material.

Further, as the metal substrates, use were made of strips of thickness 0.1 mm and width 20 mm made of: JIS Alloy C5210R (phosphor bronze, manufactured by Furukawa Electric Co., Ltd.); C7701 R (nickel silver, manufactured by MITSUBISHI ELECTRIC METECS, Co., Ltd.); and SUS304CPS (stainless steel, manufactured by Nisshin Steel Co., Ltd.), respectively. The strips were subjected to the steps of: electrolytic degreasing; acid pickling; water washing; and drying, in this order, in a usual manner.

The materials for electrical/electronic parts according to the Examples and the Comparative examples, as shown in Table 2 and Table 3, were obtained, by applying the polyimide resin-based, or polyamideimide resin-based insulating coating, directly at the center portion in the transverse direction of the metal substrate to have a stripe shape of thickness 10 µm (±1 µm) and width 10 mm (±1 mm)), followed by, in a usual manner, heating, to achieve curing of the coating and solvent drying, thereby to provide the resin coating.

With respect to the thus-obtained materials for electrical/electronic parts, a peel strength (kN/m) was measured, with reference to IPC-TM-650 2.4.9. (Peel Strength, Flexible Printed Wiring Materials). The measurement was carried out by pulling the resin portion of the sample, cut to 3.2mm-width, at a tensile speed of 50 mm/min, over a length of 228.6 mm. The results are shown in Table 2 and Table 3.

Further, the obtained materials for electrical/electronic parts were subjected to evaluation tests on a punching property and a bending property.
The test for evaluating the punching property was carried out, by punching out each sample into a rectangular shape of 5 mm x 10 mm with a die with clearance 5%, and immersing the resultant cut sample into an aqueous solution in which a red ink was dissolved. The sample whose peeled width of the resin at the punched end was less than 5 µm is marked "o" (good) (in particular, the peeled width was almost close to 0 (zero) is marked "oo" (excellent))", the peel width was not less than 5 µm and less than 10 µm is marked "Δ" (fair), and the peel width was 10 µm or more is marked "×" (poor). The results are shown in the columns of "Press-punching property" in Tables 2 and 3.
The test for evaluating the bending property was carried out, by bending with a die with bending angle 90 degrees by which each bending R was produced. Occurrence of, for example, peeling, cracks (crazing), and wrinkling of the resin on the inside and outside of the bent portion was observed under an optical stereomicroscope (40 × magnification), for judgment. The bending R was 0.025R, 0.050R, 0.075R, or 0.100R, in which the number corresponded to the bending radius in the unit of mm. Evaluation was made based on the bending radius at which no peeling, cracks, wrinkling, or the like of the resin occurred. The maximum bending radius is shown in Tables 2 and 3, at which no peeling, cracks, and wrinkling of the resin occurred at the inner side (inward bending) and the outer side (outward bending) upon bending.

### {Table 2}

**Table 2**

| Polyamideimide | | | | | | |
|---|---|---|---|---|---|---|
| | Resin | Base | Peel strength (kN/m) | Press-punching property | Bending property | |
| | | | | | Inward bending | Outward bending |
| Example 1 | AI-1 | Phosphor bronze | 0.73 | ○ | 0.075R | 0.025R |
| Example 2 | AI-1 | nickel silver | 0.65 | ○ | 0.075R | 0.025R |
| Example 3 | AI-1 | SUS | 0.75 | ○ | 0.050R | 0.025R |
| Example 4 | AI-2 | Phosphor bronze | 0.69 | ○ | 0.050R | 0.025R |
| Example 5 | AI-2 | nickel silver | 0.79 | ○ | 0.050R | 0.025R |
| Example 6 | AI-2 | SUS | 0.83 | ○ | 0.050R | 0.025R |
| Example 7 | AI-3 | Phosphor bronze | 0.88 | ○○ | 0.050R | 0.025R |
| Example 8 | AI-3 | nickel silver | 0.85 | ○○ | 0.050R | 0.025R |
| Example 9 | AI-3 | SUS | 0.94 | ○○ | 0.050R | 0.025R |
| Example 10 | AI-4 | Phosphor bronze | 1.12 | ○○ | 0.050R | 0.025R |
| Example 11 | AI-4 | nickel silver | 1.07 | ○○ | 0.050R | 0.025R |
| Example 12 | AI-4 | SUS | 1.15 | ○○ | 0.050R | 0.025R |
| Example 13 | AI-5 | Phosphor bronze | 1.01 | ○○ | 0.050R | 0.025R |
| Example 14 | AI-5 | nickel silver | 1.02 | ○○ | 0.050R | 0.025R |
| Example 15 | AI-5 | SUS | 1.05 | ○○ | 0.050R | 0.025R |
| Example 16 | AI-6 | Phosphor bronze | 0.71 | ○ | 0.050R | 0.025R |
| Example 17 | AI-6 | nickel silver | 0.75 | ○ | 0.050R | 0.025R |
| Example 18 | AI-6 | SUS | 0.79 | ○ | 0.050R | 0.025R |
| Example 19 | AI-7 | Phosphor bronze | 0.93 | ○○ | 0.075R | 0.025R |
| Example 20 | AI-7 | nickel silver | 0.93 | ○○ | 0.075R | 0.025R |
| Example 21 | AI-7 | SUS | 1.02 | ○○ | 0.075R | 0.025R |
| Comparative example 1 | AI-0 | Phosphor bronze | 0.53 | × | 0.075R | 0.050R |
| Comparative example 2 | AI-0 | nickel silver | 0.56 | × | 0.075R | 0.050R |
| Comparative example 3 | AI-0 | SUS | 0.56 | × | 0.075R | 0.050R |
| Comparative example 4 | HI-406A | Phosphor bronze | 0.55 | △ | 0.100R | 0.050R |
| Comparative example 5 | HI-406A | nickel silver | 0.54 | △ | 0.100R | 0.050R |
| Comparative example 6 | HI-406A | SUS | 0.57 | △ | 0.075R | 0.050R |

### {Table 3}

**Table 3**

| Polyimide | | | | | | |
|---|---|---|---|---|---|---|
| | Resin | Base | Peel strength (kN/m) | Press-punching property | Bending property | |
| | | | | | Inward bending | Outward bending |
| Example 22 | PI-1 | Phosphor bronze | 1.09 | ○○ | 0.075R | 0.025R |
| Example 23 | | nickel silver | 1.07 | ○○ | 0.075R | 0.025R |
| Example 24 | | SUS | 1.11 | ○○ | 0.075R | 0.025R |
| Example 25 | PI-2 | Phosphor bronze | 1.08 | ○○ | 0.075R | 0.025R |
| Example 26 | | nickel silver | 1.06 | ○○ | 0.075R | 0.025R |
| Example 27 | | SUS | 1.08 | ○○ | 0.075R | 0.025R |
| Comparative example 7 | PyreML | Phosphor bronze | 0.85 | ○ | 0.100R | 0.075R |
| Comparative example 8 | | nickel silver | 0.84 | ○ | 0.100R | 0.075R |
| Comparative example 9 | | SUS | 0.88 | ○ | 0.100R | 0.075R |

As is apparent from Table 2, Examples 1 to 21 in which the coating was provided with the polyamideimide having the structure represented by formula (I) or (II) in the molecule, each had a higher peel strength and an improved adhesiveness, as compared to Comparative Examples 1 to 6 in which the coating was provided with the polyamideimide not having such a structure represented by formula (I) or (II) in the molecule. Further, with respect to the punching property, the peeled width of the resin was 5 µm or more at the punched end in Comparative examples, while it was less than 5 µm in Examples. Further, the bending property of Examples was at least the same level as or better to that in Comparative examples. In particular, according to Examples 10 to 15 in which AI-4 and A-5 were used, respectively, regardless of the type of the base, the peel strength was remarkably enhanced, i.e. about two times, as compared to Comparative examples; and Examples 10 to 15 exhibited the excellent workability in that the peeled width of the resin was almost close to 0 (zero) at the punched end, and no peeling, cracks, and wrinkling of the resin occurred upon the inward bending with 0.050R and the outward bending with 0.025R. Among them, according to Examples 10 to 12 in which AI-4 was used, the adhesiveness between the metal substrate and the resin coating was remarkably excellent.
Similarly, as is apparent from Table 3, Examples 22 to 27 in which the coating was provided with the polyimide having the structure represented by formula (I) or (II) in the molecule, each had a higher peel strength, an improved adhesiveness, and an excellent workability, as compared to Comparative examples 7 to 9 in which the coating was provided with the polyimide not having such a structure represented by formula (I) or (II) in the molecule.

Having described our invention as related to the present embodiments, it is our intention that the invention not be limited by any of the details of the description, unless otherwise specified, but rather be construed broadly within its spirit and scope as set out in the accompanying claims.

This application claims priority on Patent Application No. 2008-046021 filed in Japan on February 27, 2008, which is entirely herein incorporated by reference.

## Claims

1. A material for an electrical/electronic part, comprising a resin coating directly formed on at least a part of a metal substrate or at least a part of a metal layer provided on the metal substrate, with the resin coating being formed with a resin composition containing at least one selected from the group consisting of a polyamideimide resin and a polyimide resin, each having a structure represented by formula (I) in the molecular structure of the resin, and/or a resin composition containing at least one selected from the group consisting of a polyamideimide resin and a polyimide resin, each having a structure represented by formula (II) in the molecular structure of the resin: 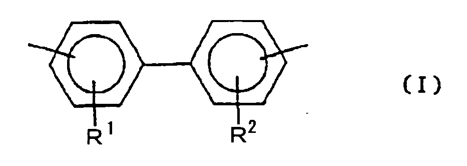 wherein R¹ represents one selected from a hydrogen atom, an alkyl group, a hydroxyl group, a halogen atom, and an alkoxy group; and R² represents one selected from a hydrogen atom, an alkyl group, a hydroxyl group, a halogen atom, and an alkoxy group, and 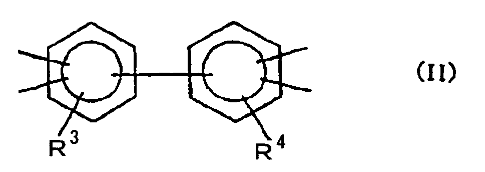 wherein R³ represents one selected from a hydrogen atom, an alkyl group, a hydroxyl group, a halogen atom, and an alkoxy group; and R⁴ represents one selected from a hydrogen atom, an alkyl group, a hydroxyl group, a halogen atom, and an alkoxy group.

2. The material for an electrical/electronic part according to claim 1, wherein a part or the entire of the insulating layer comprises a repeating unit derived from a monomer component having the structure represented by formula (I), and/or a repeating unit derived from a monomer component having the structure represented by formula (II), in an amount of 20 to 60 mol% to all the repeating units.

3. The material for an electrical/electronic part according to claim 1, wherein a part or the entire of the insulating layer comprises a repeating unit derived from a monomer component having the structure represented by formula (I), and/or a repeating unit derived from a monomer component having the structure represented by formula (II), in an amount of 35 to 55 mol% to all the repeating units.

4. The material for an electrical/electronic part according to any one of claims 1 to 3, which has one or more layers of the resin coating on the metal substrate.

5. The material for an electrical/electronic part according to any one of claims 1 to 4, wherein the metal substrate is composed of copper or a copper-based alloy, or iron or an iron-based alloy.

6. The material for an electrical/electronic part according to any one of claims 1 to 5, wherein n metal layers are provided on the metal substrate, in which n is an integer of 1 or more, and wherein the resin coating is provided on the metal substrate, directly or via at least one layer of the metal layer.

7. An electrical/electronic part, comprising the material for an electrical/electronic part according to any one of claims 1 to 6.
